Europäisches Patentamt

European Patent Office

Office européen des brevets

(11) Publication number: **0 205 635**
**A1**

## (12) EUROPEAN PATENT APPLICATION

(21) Application number: **85107803.0**

(22) Date of filing: **25.06.85**

(51) Int. Cl.⁴: **H 01 L 29/78, H 03 K 17/687**

(43) Date of publication of application: **30.12.86**
**Bulletin 86/52**

(84) Designated Contracting States: **DE FR GB NL**

(71) Applicant: **EATON CORPORATION, Eaton
Center 111 Superior Ave., Cleveland Ohio 44114 (US)**

(72) Inventor: **Benjamin, James Anthony, 20865 Hawthorne
Ridge Court, Waukesha Wisconsin 53186 (US)**
Inventor: **Lade, Robert Walter, 1009 North Jackson
Street Apt. 2302, Milwaukee Wisconsin 53202 (US)**
Inventor: **Schutten, Herman Peter, 8545 North Fielding
Road, Bayside Wisconsin 53217 (US)**

(74) Representative: **Wagner, Karl H., WAGNER & GEYER
Patentanwälte Gewuerzmuehlstrasse 5 Postfach 246,
D-8000 München 22 (DE)**

(54) **Bidirectional power fet with bipolar on-state.**

(57) A gating technique is disclosed for split gate bidirectional power FET structure (2), including AC application. First and second channels (14, 16) are initially gated ON to provide fast field effect turn-on. One of the channels such as (14) is then gated OFF such that current is instead injected across the junction (18) between the drift region (4) and the respective channel-containing region (6) to afford bipolar conduction, which is desirable because of its lower ON state resistance. The noted channel such as (14) is then gated back ON to again afford field effect conduction between source regions (10, 12) and enable fast turn-off.

EP 0 205 635 A1

# BIDIRECTIONAL POWER FET WITH BIPOLAR ON-STATE

## Background and Summary

The invention relates to power switching semiconductors, and more particularly to power MOSFETs metal oxide semiconductor field effect transistors), and the like.

The present invention relates to an improved gating technique providing both field effect and bipolar action in AC power FET structure such as shown in copending Application Serial Numbers 390,562 and 390,479, filed June 21,1982, and Serial Number 421,931, filed September 23,1982. These Applications disclose lateral FET structure for bidirectional power switching, including AC application. Laterally spaced source regions and channel regions have a common drift region therebetween. Upon application of voltage of either polarity across main terminals connected to the source regions, current flow in either direction is controlled by the potential on split gate electrode means proximate the channels.

The present invention provides a gating technique for accomplishing both field effect and bipolar action, for realizing desirable characteristics of each. The AC power FET is initially gated ON in a field effect mode, followed by a bipolar mode affording low ON state resistance, followed by gating back to a field effect mode to enable fast turn-off. Initially, both of the split gates are turned ON to provide field effect turn-on. One of the split gates is then turned OFF to remove the short across its respective channel-drift region junction, such that current is instead injected across the latter junction, affording bipolar conduction and low ON state resistance. The latter gate is then turned back ON to again afford field effect conduction between the source regions, for enabling fast turn-off.

-2-

## Brief Description of the Drawings

Fig. 1 is a schematic sectional view for illustrating the gating technique of the present invention.

Fig. 2 is shows an alternate embodiment.

## Detailed Description

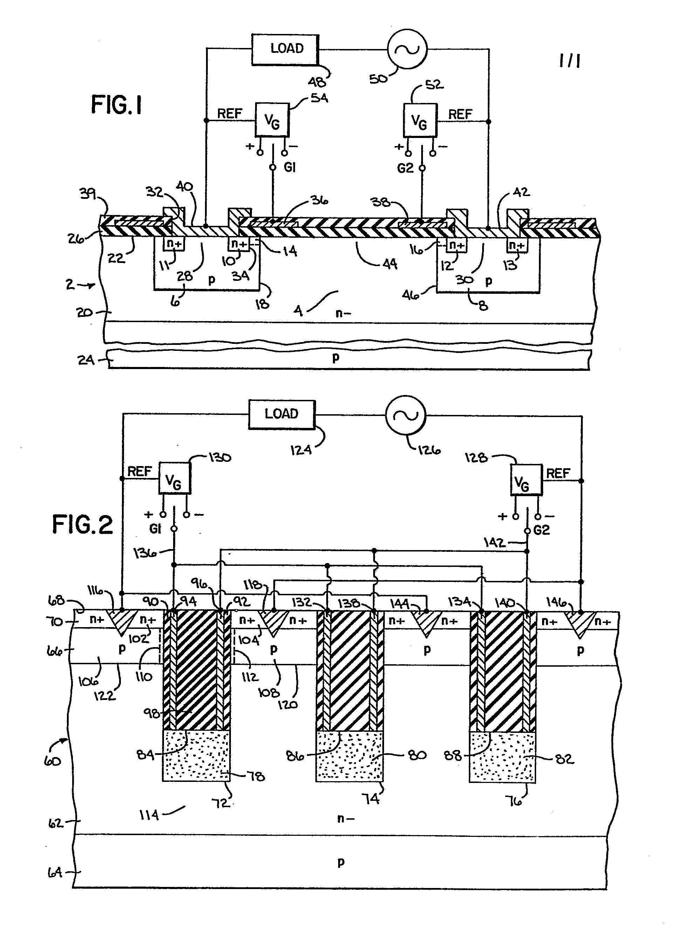

Fig. 1 shows a split gate bidirectional power FET 2 having a common drift region 4 between a pair of spaced first and second channel-containing regions 6 and 8 and first and second source regions 10 and 12. The first and second channels 14 and 16 are gated ON to invert the conductivity type thereof and afford conduction between source regions 10 and 12 through drift region 4. One of the channels, for example channel 14 if current is flowing left to right, is then gated OFF such that current is instead injected across the junction, such as 18, between drift region 4 and the channel-containing region such as 6. This affords bipolar conduction across drift region 4 between channel-containing regions 6 and 8. The bipolar action provides lower ON state resistance than field effect action. The noted channel, such as 14, is then gated back ON to again afford field effect conduction between source regions 10 and 12. Field effect action enables faster turn-off than bipolar action because stored charge need not be swept out.

Referring to Fig. 1, FET 2 includes a substrate 20 of semiconductor material of one conductivity type having a top major surface 22. In preferred form, substrate 20 is an n-epitaxial layer grown on a base layer of semiconductor material such as p layer 24. A pair of p tub regions 6 and 8 are diffused into substrate 20 through holes in silicon dioxide insulating layer 26 on top major surface 22. N+ regions 10, 11 and 12, 13 are diffused into respective p regions 6 and 8 through the same holes in the oxide layer, in accordance with known double diffusion processing technology. N+ regions 10, 11 are prevented from forming in the central section 28 of p region 6 by a separate masking step, or in accordance with known SIPMOS processing technology, and likewise for central secetion 30 of p tub 8. Both the p and n+ diffusions are performed through the same hole, and thus the oxide edge such as 32 provides aligned registry. The diffusion parameters control the lateral penetration of p edge 18 and n+ edge 34, which in turn control the lateral length of channel 14 therebetween, and likewise for channel 16. Laterally spaced split gate electrodes 36 and 38 are deposited through an appropriate mask, followed by a top silicon dioxide insulating layer 39. Split gate electrodes 36 and 38 are insulated above and extend across respective channels 14 and 16. Main electrodes 40 and 42 are deposited in respective openings to ohmically contact respective source regions 10, 11 and 12, 13 and respective channel-containing regions 6 and 8.

Upon application of positive voltage to right gate electrode 38 with respect to right main electrode 42, electrons in p region 8 are attracted to top major surface 22 to thus invert the conductivity type in channel 16 to n type. Likewise upon application of positive voltage to left gate electrode 36 with respect to left main electrode 40, electrons in p region 6 are attracted to top major surface 22 to thus invert the conductivity type in channel 14 to n type. If left main electrode 40 is positive with respect to right

-4-

main electrode 42, current may then flow from left main electrode 40, through left source region 10, through left channel 14, through drift region 4 along conduction path 44 beneath top major surface 22, then through right channel 16, through right source region 12, to right main electrode 42. The current in unipolar, i.e. consists only of majority carrier flow.

The structure is bidirectional, and thus current may also flow from right main electrode 42 to left main electrode 40 when electrode 42 is positive with respect to electrode 40, and when the gates are turned ON, i.e. made positive with respect to their respective main electrodes.

In the gating technique of the present invention, after initial field effect turn-on, one of the gates is turned OFF to provide bipolar conduction. For example, with FET 2 turned ON and current flowing from left main electrode 40 to right main electrode 42, left gate electrode 36 is turned OFF by making it negative with respect to left main electrode 40. Negative left gate electrode 36 attracts holes in p region 6 to thus revert channel 14 back to p type, thus rendering channel 14 nonconductive. Current instead flows across junction 18 by means of minority carrier injunction of holes from p region 6 into drift region 4. This bipolar conduction provides desirable lower ON state resistance. Furthermore, the injection across forward biased PN junction 18 provides a larger area current source than point source 14, and thus uses more of substrate 4, not just the narrow conduction path 44 beneath top major surface 22. The injection across forward biased junction 18 affords conductivity modulation through substrate 4 and bipolar action at reverse biased junction 46.

In the OFF state, current from left main electrode 40 to right main electrode 42 is blocked by reversed biased PN junction 46. Right gate electrode 38 is turned OFF so that channel 16 is p type. Current flow in the other direction from right main electrode 42 to left main electrode 40 is blocked by junction 18, with left gate electrode 36 being turned OFF such that channel 14 is p type.

In accordance with an OFF state gating technique disclosed in copending Application Attorney's Docket F9768-9, during the OFF state, the gate electrode corresponding to the forward biased junction is turned ON to short such junction. For example if left main electrode 40 is positive with respect to right main electrode 42 during the OFF state, then left gate electrode 36 is turned ON by making it positive with respect to left main electrode 40. Positive gate electrode 36 attracts electrons in p region 6 toward top major surface 22 to invert channel 14 to n type and allow majority carrier flow therethrough between source region 10 and drift region 4, which shorts junction 18 and prevents minority carrier injection thereacross. Minority carrier injection across forward biased junction 18 is desirable in the OFF state because of the consequent bipolar PNP action between region 6, 4 and 8. This bipolar action reduces the OFF state voltage blocking capability. By shorting junction 18 and preventing minority carrier injection thereacross, the OFF state voltage is dropped across single reverse biased PN junction 46. This reverse biased junction can support higher OFF state voltage without the injection and bipolar action from junction 18.

Bidirectional FET 2 may be used to control AC power. FIG. 1 schematically shows a load 48 and a source of AC power 50 connected across main electrodes 40 and 42. During the first half cycle of AC source 50, with left main electrode 40 positive with respect to right main electrode 42, switch G2 is in its leftward position such that gating potential source 52 biases right gate electrode 38 positively with respect to reference right main electrode 42. Channel 16 is thus inverted to n type. For fast turn-on switch G1 is in its leftward position such that left gate electrode is biased positively with respect to left main electrode by gating potential source 54. Channel 14 is thus inverted to n type and conduction occurs as above described. In an alternative, if left gate electrode 36 is not biased positively with respect to left main electrode 40, then current initally flows across forward biased PN junction 18. As soon as the current starts to flow through the FET, the voltage across the main electrodes drops, which in turn reduces the potential in various regions inthe FET including the portion of p region 6 below channel 14, which dropping potential may become negative relative to left gate electrode 36, whereby the latter attracts electrons toward top major surface 22 to invert channel 14 to n type and hence render channel 14 conductive. Initial fast turn-on by field effect conduction is preferred.

Still during the first half cycle, after initial turn-on, G1 is switched to its rightward position such that left gate electrode 36 is made negative with respect to left main electrode 40. This reverts channel 14 back to p type and thus forces current across forward biased PN junction 18, causing the above-noted minority carrier injection and bipolar conduction.

Before the end of the first half cycle, G1 is switched back to its leftward position, making left gate electrode 36 positive with respect to left main electrode 40, and again inverting channel 14 to n type to thus short junction 18, and provide field effect conduction. This field effect conduction enables fast turn-off at the end of the first half cycle.

Operation during the second half cycle, with current flow leftwardly from right main electrode 42 to left main electrode 40, is comparable to that above described.

The gating technique of the invention may be used in a multi-cell matrix array incorporating a plurality of bidirectional power FETs integrated on a common substrate. For example, region 11 is part of the next FET cell to the left, and region 13 is part of the next FET cell to the right. Multi-cell gating is shown in FIG. 2, together with various alternatives.

FIG. 2 shows bidirectional power FET structure 60 including a substrate 62 of one conductivity type, such as n type, having a bottom layer 64 of opposite conductivity type, such as p type. A top p layer 66 is diffused or grown into the substrate from top major surface 68, followed by ion implantation and/or diffusion of an n+ top layer 70.

A plurality of notches 72, 74 76 and so on, are formed in the substrate from top major surface 68 through n+ layer 70 and through p top layer 66 into substrate region 62. These notches may be anisotropically etched, as known in the art: C. Hu, "A Parametric Study of Power MOSFETs", IEEE Electron Device Conference, Paper CH1461-3/79, 0000-0385; IEEE Transactions Electron Devices, Volume ED-25, No. 10, October 1978; and Ammar and Rogers, "UMOS Transistors on Silicon", Transactions IEEE, ED-27, pages 907-914, May, 1980. Alternatively, the notches may be formed by a porous silicon region in accordance with the known anodization technique of passing a fixed current through the localized region in the presence of concentrated hydrogen fluoride to create a structural change in the silicon which remains single crystalline with the substrate but becomes porous. In the case of anisotropic etching the bottom of the notch is filled with insulative material. In the case of anodization, the substrate is subjected to an oxidizing atomosphere such that the oxygen enters the pores in the porous notched regions and rapidly oxidizes these regions as shown at 78, 80, 82, and so on, which regions are still single crystaline with substrate 62 but substantially nonconductive. Before or after the anodization, the notches are etched down to levels 84, 86, 88 and so on.

In notch 72, silicon dioxide insulating layers 90 and 92 are grown along the inner facing surfaces of the notch. First and second split gate electrodes 94 and 96 are then formed along the left and right vertical sides of the notch, as by shadow evaporation of conductive material such as aluminum from an angle or low pressure chemical desposition (LPCVD) of polysilicon. Another insulating oxide layer 98 is provided in the middle of the notch between the gate electrodes, as by chemcial vapor deposition. The insulated gating structure in notches 74 and 76 is comparable.

Notch 72 extends from top major surface 68 downwardly through top layers 70 and 66 into substrate region 62. Notch 72 separates top layer 70 into first and second left and right source regions 102 and 104 and extends therebetween. Notch 72 separates top layer 66 into first and second regions 106 and 108 containing left and right channels 110 and 112 and extends therebetween. Substrate 62 around the notch forms a drain or drift region 114 of the substrate. Main electrode metallization 116 is deposited on top major surface 68 in an etched groove to ohmically contact source region 102 and channel-containing region 106. Another main electrode metallization 118 is deposited on top major surface 68 in an etched groove to ohmically contact source region 104 and channel-containing region 108. In an alternative, the etched groove for the main electrode metallization may extend downwardly into substrate 62 followed by deposition of a thin p layer along the inner surface of the groove followed by deposition of the main electrode metallization.

Upon application of positive voltage to left gate electrode 94 with respect to left main electrode 116, electrons in p region 106 are attached to channel 110 to invert the conductivity type therein to n type. This allows electron flow from n+ source region 102 through channel 110 into drift region 114 in substrate 62. If right main electrode 118 is positive with respect to left main electrode 116, current may then flow from p region 108 across forward biased PN junction 120, or current may flow through channel 112 from source 104 if the channel is inverted to n type by a positive voltage on right gate electrode 96 relative to right main electrode 118. The latter is preferred for fast turn-on as above noted.

The main current path through FET 60 at turn-on from right main electrode 118 through right source region 104, downwardly through right vertical channel 112 along the right side of notch 72, then further downwardly into drift region 114 along the right side of the notch, then around the bottom of notch 72, then upwardly along the left side of notch 72 in drift region 114 of substrate 62, then upwardly through left vertical channel 110 along the left side of notch 72, then through left source region 102 to left main electrode 116.

-10-

During initial fast turn-on, current flow is unipolar due to the field effect action. Electrons are the majority carriers, and the sole current carrier flow. Electrons flow from n region 102 through induced n region 110, through n region 62, through induced n region 112, through n region 104.

After initial field effect turn-on, the device is switched to a bipolar mode. Bipolar action is effected by making right gate.electrode 96 negative with respect to right main electrode 118. The relatively negative right gate electrode 96 attracts holes in p region 108 towards the right side of notch 72 and causes channel 112 to revert back to p type, and thus causing current to cross junction 120. Current crosses junction 120 by means of minority carrier injection, thus effecting bipolar conduction. Current flows by means of both majority and minority carrier flow.

Prior to turn-off, gate 96 is turned back ON, i.e., made positive with respect to right main electrode 118, to thus invert channel 112 back to n type. This affords field effect conduction again, enabling fast turn-off.

The structure is bidirectional, and thus current may also flow from left main electrode 116 to right main electrode 118 comparably to that above described.

The OFF state of FET 60 is comparable to that above described, with junction 122 blocking current flow from right main electrode 118 to left main electrode 116, and with junction 120 blocking current flow in the reverse direction.

As with power FET 2, FET 60 may be used to control AC power. FIG. 2 shows a load 124 and a source of AC power 126 connected across main electrodes 116

-11-

and 118. Gating potential sources 128 and 130 operate analogously to voltage sources 52 and 54, respectively.

As seen in FIG. 2, a plurality of FETs are afforded in the integrated structure. Top layer 66 and 70 are further split into respective left and right source regions and channel regions by notches 74 and 76. Main electrode metallizations are provided comparably to that described, and connected in series in the AC load line, or in parallel as shown in FIG.2. Left gate electrodes 132 and 134 are connected in parallel with left gate electrode 94 to left gate terminal 136. Right gate electrodes 138 and 140 are connected in parallel with right gate electrode 96 to right gate terminal 142.

In one of the half cycles of AC source 126, main electrode 118 provides the source electrode for the FET to the left around notch 72, and also provides the source electrode for the FET to the right around notch 74. Main electrode 144 provides the drain electrode for the FET around notch 74 and also provides the drain electrode for the FET around notch 76. In the other half-cycle of AC source 126, the roles of electrode 118 and 144 are reversed, i.e., electrode 118 is the drain for its left and right FETs around respective notches 72 and 74, and electrode 144 is the source for its left and right FETs around respective notches 74 and 76. Alternate main electrodes 116, 144 and so on, are thus connected to one side of the AC source, and the other alternate main electrodes 118, 146 and so on, are connected to the other side of the AC source.

It is recognized that various modifications are possible within the scope of the appended claims.

-12-

CLAIMS

1. In a split gate bidirectional power FET having a common drift region between a pair of spaced first and second channel-containing regions and first and second source regions, an improved gating technique providing both field effect and bipolar characteristics comprising gating ON the first and second channels to invert the conductivity type thereof and afford conduction between said source regions through said drift region, then gating OFF one of said channels such that current is instead injected across the junction between said drift region and the respective channel-containing region to afford bipolar conduction across said drift region between said channel-containing regions, said bipolar action providing lower ON state resistance, and then gating said one channel back ON again to afford field effect conduction between said source regions, said field effect action enabling fast turn-off.

2. The invention according to claim 1 wherein:

said first source region is of one type semiconductor material;

said first channel-containing region is of opposite conductivity type semiconductor material and forms a junction with said first source region;

said drift region is of said one conductivity type semiconductor material and forms another junction with said first channel-containing region;

said second channel-containing region is of said opposite conductivity type semiconductor material and forms a junction with said drift region;

said second source region is of said one conductivity type semiconductor material and forms a junction with said second channel-containing region;

-13-

and comprising split gate electrode means including a first gate electrode disposed proximate first channel and a second gate electrode disposed proximate said second channel, and adapted for application of electrical potential for producing electric fields of sufficient intensity to invert the conductivity type in said first and second channels;

whereby application of voltage of either polarity to said first and second source regions, electric current can flow in a respective corresponding direction between them, under control of said electrical potential of said gate electrode means.

3. The invention according to claim 2 comprising:

first and second main electrodes each connected to a respective source region and channel-containing region;

said FET having an OFF state in the absence of said electric gate potential, with the junction between said drift region and said first channel-containing region blocking current flow from said second main electrode towards said first main electrode, and with the junction between said drift region and said second channel-containing region blocking current flow from said first main electrode toward said second main electrode.

4. The invention according to claim 3 wherein said main electrodes are connectable to an AC load line;

said gate electrodes are connectable to respective gate potential source means;

such that during the first half cycle of said AC line, said first main electrode is positive with respect to said second main electrode, and each said gate electrode is positive with respect to its respective said main electrode to attract given polarity carriers into the respective said channels and invert the latter to said one conductivity type, whereby unipolar current flows from said first main electrode through said first source region, through said first channel, through said drift region, through said second channel, through said second source region to said second main electrode, said conduction being due to field effect action, said first gate electrode then being made negative with respect to said first main electrode such that said first channel reverts back to said opposite conductivity type causing current to instead be injected across said junction between said first channel-containing region and said drift region, said injected current affording bipolar conduction through said drift region between said source regions and said main electrodes, said first gate electrode then being made positive again with respect to said first main electrode to invert said first channel back to said one conductivity type and again afford field effect unipolar conduction at the end of said first half cycle; and

such that during the second half cycle of said AC line, said second main electrode is positive with respect to said first main electrode, and each said gate electrode is positive with respect to its respective main electrode to attract given polarity characters into the respective said channels and invert the latter to said one conductivity type, whereby unipolar current flows from said second main electrode through said second source region, through said second channel, through said drift region, through said first channel, through said first source region to said first main electrode, said conducting being due to field effect action, said second gate electrode then being made negative with respect to said second main electrode such that said second channel reverts back to said opposite conductivity type causing current to instead be injected across said junction between said second channel-containing region and said drift region, said injected current affording bipolar conduction through said drift region between said source regions and said main electrodes, said second gate electrode then being made positive again with respect to said second main electrode to invert the said second channel back to said one conductivity type and again afford field effect unipolar conduction at the end of said second half cycle.

5. The invention according to claim 2 wherein:

said channels extend horizontally along a top major surface between a respective said source region and said drift region; and

said first and second gate electrodes extend horizontally along said top major surface above respective said channels.

6. The invention according to claim 5 wherein:

said channel-containing regions are laterally spaced by said drift region extending upwardly between said channel-containing regions to said top major surface;

said source regions are laterally spaced along said top major surface; and

said channel-containing regions and said drift region are disposed between said source regions.

7. The invention according to claim 2 comprising notch means extending between and separating said first and second source regions and said first and second channel-containing regions, and extending into said drift region.

8. The invention according to claim 7 wherein:

said channel-containing regions are laterally spaced by said notch means; and

said notch means extends downwardly from a top major surface of said FET;

said channels extend generally vertically along respective sides of said notch means; and

said drift region is below said channels.

9. The invention according to claim 8 wherein said source regions are laterally spaced along said top major surface by said notch means therebetween, said source regions being above respective said channels.

10. The invention according to claim 9 wherein the drift region current path between said main electrodes extends from said source regions downwardly through said channels and downwardly and around the bottom of said notch means.

FIG.1

FIG.2

European Patent
Office

**EUROPEAN SEARCH REPORT**

Application number

EP 85 10 7803

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 199 774 (THE BOARD OF TRUSTEES OF THE LELAND STANFORD JUNIOR UNIVERSITY) <br> * Figure 9; page 6, lines 11-21,45-55 * | 1 | H 01 L 29/78 <br> H 03 K 17/687 |
| A | EP-A-0 099 175 (EATON CORP.) <br><br> * Figure 13; abstract * | 1-3,5, 6 | |
| A | EP-A-0 097 442 (EATON CORP.) <br> * Figures 13,21; abstract * | 1,7-10 | |
| A | US-A-4 477 742 (EATON CORP.) <br> * Figure; page 1, lines 28-32; page 1, line 62 - page 2, line 19 * | 1 | |

TECHNICAL FIELDS
SEARCHED (Int. Cl.4)

H 01 L
H 03 K

The present search report has been drawn up for all claims

| Place of search | Date of completion of the search | Examiner |
|---|---|---|
| THE HAGUE | 11-03-1986 | GELEBART J.F.M. |